# EUROPÄISCHE PATENTSCHRIFT

(11) **EP 3 063 848 B1**
(45) Veröffentlichungstag und Bekanntmachung des Hinweises auf die Patenterteilung: **30.05.2018**
(21) Anmeldenummer: 14792448.4
(22) Anmeldetag: 28.10.2014
(51) Int. Cl.: H02G 3/08, H05K 5/02

(54) **GEHÄUSE MIT BELÜFTUNGSELEMENT**
HOUSING HAVING A VENTILATION ELEMENT
BOÎTIER POURVU D'UN ÉLÉMENT DE VENTILATION

(30) Priorität: 30.10.2013 DE 102013111992
(43) Veröffentlichungstag der Anmeldung: 07.09.2016
(73) Patentinhaber: Günther Spelsberg GmbH & Co. KG, 58579 Schalksmühle (DE)
(72) Erfinder: EICHSTÄDT, Andreas, 58579 Schalksmühle (DE); SPELSBERG, Holger, 58579 Schalksmühle (DE)
(74) Vertreter: Michalski Hüttermann & Partner Patentanwälte mbB
(86) Internationale Anmeldenummer: PCT/EP2014/073071
(87) Internationale Veröffentlichungsnummer: WO 2015/063057

(56) Entgegenhaltungen:
- DE-A1-102007 012 703
- GB-A- 2 500 068
- US-A1- 2003 047 562

## Beschreibung

Die Erfindung betrifft ein Gehäuse, insbesondere ein Elektroinstallationsgehäuse, mit einer eine innere Belüftungsöffnung aufweisenden Gehäusewandung und einem in der Gehäusewandung vorgesehenen Belüftungselement, wobei das Belüftungselement als Drehverschluss zum Öffnen bzw. Schließen der inneren Belüftungsöffnung ausgestaltet ist und der Drehverschluss auf seiner der Gehäusewandung zugewandten Seite eine erste labyrinthartige Kontur aufweist, die Gehäusewandung auf ihrer Außenseite eine die innere Belüftungsöffnung umgebende zweite labyrinthartige Kontur aufweist, und die erste labyrinthartige Kontur des Drehverschlusses in die zweite labyrinthartige Kontur der Gehäusewandung eingreift. Ein derartiges Gehäuse ist aus der GB 2 500 068 A bekannt.

Im Bereich der Elektrotechnik sind verschiedene Arten von Elektroinstallationsgehäusen bekannt. Diese dienen z.B. dem Schutz elektrischer Bauteile vor Staub und Wasser. Derartige Elektroinstallationsgehäuse werden gemäß der DIN EN 60529 in IP-Schutzklassen eingeteilt, wobei die erste Kennziffer den Schutzgrad gegen Staub und die zweite Kennziffer den Schutzgrad gegen Wasser angibt. Dabei wird beim Schutz gegen Staub zwischen den Klassen 0 bis 6 und beim Schutz gegen Wasser zwischen den Klassen 0 bis 8 unterschieden. In der Regel gilt, je höher die Ziffer, desto besser der Schutz.

Die Anwendung staubdichter und gegen starkes Strahlwasser geschützter Elektroinstallationsgehäuse mit einer Schutzklasse IP 66 im Innenbereich ist in der Regel unproblematisch. Im Außenbereich können allerdings große Temperatur- und Druckunterschiede zwischen dem geschlossenen Elektroinstallationsgehäuse und der das Elektroinstallationsgehäuse umgebenden Luft, insbesondere bei Elektroinstallationsgehäusen mit einer hohen Schutzklasse, zu einer erheblichen Kondensation im Elektroinstallationsgehäuse führen.

Es ist die Aufgabe der Erfindung, ein Elektroinstallationsgehäuse auf universelle Art mit einer hohen IP-Schutzklasse auszurüsten, wobei Temperatur- und Druckunterschiede zur Umgebung auf einfache Weise ausglichen werden.

Diese Aufgabe wird durch die Gegenstände der unabhängigen Ansprüche gelöst. Bevorzugte Weiterbildungen sind in den Unteransprüchen angegeben.

Erfindungsgemäß ist ein Gehäuse, insbesondere ein Elektroinstallationsgehäuse, vorgesehen, mit einer eine innere Belüftungsöffnung aufweisenden Gehäusewandung und einem in der Gehäusewandung vorgesehenen Belüftungselement, wobei das Belüftungselement als Drehverschluss zum Öffnen bzw. Schließen der inneren Belüftungsöffnung ausgestaltet ist und der Drehverschluss auf seiner der Gehäusewandung zugewandten Seite eine erste labyrinthartige Kontur aufweist, die Gehäusewandung auf ihrer Außenseite eine die innere Belüftungsöffnung umgebende zweite labyrinthartige Kontur aufweist, und die erste labyrinthartige Kontur des Drehverschlusses in die zweite labyrinthartige Kontur der Gehäusewandung eingreift, dadurch gekennzeichnet, dass die zweite labyrinthartige Kontur der Gehäusewandung durch eine unterbrochene Aufkantung umrandet ist und die Aufkantung wenigstens eine äußere Belüftungsöffnung aufweist.

Es ist somit ein wesentlicher Punkt der Erfindung, ein Gehäuse mit einem Belüftungselement zu versehen, das in die Gehäusewandung integrierbar ist und mindestens eine innere Belüftungsöffnung und eine zweite labyrinthartige Kontur aufweist. Der Drehverschluss weist dabei eine erste labyrinthartige Kontur auf, mit welcher er in die zweite labyrinthartige Kontur des gehäuseseitigen Belüftungselements eingreift.

Eine bevorzugte Weiterbildung der Erfindung sieht vor, dass die zweite labyrinthartige Kontur fest, vorzugsweise einstückig, mit der Gehäusewandung verbunden ist. Besonders bevorzugt ist vorgesehen, dass die zweite labyrinthartige Kontur einstückig auf der Außenseite mit der Gehäusewandung verbunden ist. Auf diese Weise kann die zweite labyrinthartige Kontur des Belüftungselements bei der Herstellung des Elektroinstallationsgehäuses, beispielsweise im Spritzgussverfahren, berücksichtigt werden. Zudem wird der Anteil zusätzlicher Aufsteckteile und/oder Anbauteile des Belüftungselements reduziert, wodurch Material eingespart wird und Arbeitsschritte reduziert werden.

Alternativ sieht eine weitere bevorzugte Weiterbildung der Erfindung vor, dass die zweite labyrinthartige Kontur über ein Aufsteckteil auf die Gehäusewandung aufgesteckt ist. Besonders bevorzugt ist vorgesehen, dass die zweite labyrinthartige Kontur über ein Aufsteckteil auf die Außenseite der Gehäusewandung aufgesteckt ist. Auf diese Weise können bereits bestehende Elektroinstallationsgehäuse mit einem Belüftungselement nachgerüstet werden. Zudem können ursprüngliche Spritzgussformen zur Herstellung der Elektroinstallationsgehäuse weiter verwendet werden. Weiterhin kann die Lage der Belüftungsöffnung situationsbedingt individuell festgelegt werden, ohne an herstellungsbedingte Vorgaben gebunden zu sein.

Eine weitere alternative bevorzugte Weiterbildung der Erfindung sieht vor, dass ein erster Teil der zweiten labyrinthartigen Kontur einstückig mit der Gehäusewandung verbunden ist und ein zweiter Teil der zweiten labyrinthartigen Kontur über ein Aufsteckteil auf die Gehäusewandung aufgesteckt ist. Besonders bevorzugt ist dabei vorgesehen, dass ein erster Teil der zweiten labyrinthartigen Kontur einstückig mit der Außenseite der Gehäusewandung verbunden ist und ein zweiter Teil der zweiten labyrinthartigen Kontur über ein Aufsteckteil auf die Außenseite der Gehäusewandung aufgesteckt ist. Auf diese Weise sind Elektroninstallationsgehäuse herstellbar, bei denen die Lage der Belüftungsöffnung bereits im Herstellprozess vorgegeben wird, der zweite Teil der zweiten labyrinthartigen Kontur jedoch auf das jeweilige Belüftungserfordernis individuell abgestimmt und nachträglich aufgesteckt werden kann.

In diesem Zusammenhang sieht eine bevorzugte Weiterbildung der Erfindung vor, dass der Drehverschluss in seiner Umrandung wenigstens eine äußere Belüftungsöffnung aufweist. Besonders bevorzugt ist vorgesehen, dass die Umrandung des Drehverschlusses eine Mehrzahl radial umlaufende äußere Belüftungsöffnungen aufweist.

Eine bevorzugte Weiterbildung der Erfindung sieht vor, dass die innere Belüftungsöffnung der Gehäusewandung oder die innere Belüftungsöffnung des Aufsteckteils eine Verstrebung aufweist. Vorzugsweise ist vorgesehen, dass die Verstrebung einen Ring umfasst, der mit mindestens drei beabstandeten Streben in der inneren Belüftungsöffnung positioniert ist. Die Verstrebung innerhalb der inneren Belüftungsöffnung dient einerseits einer Verrastung des Drehverschlusses mit der Gehäusewandung oder dem auf die Gehäusewandung aufgesteckten Aufsteckteil und andererseits als Auflager für einen Filter.

Eine weitere bevorzugte Weiterbildung der Erfindung sieht vor, dass der Drehverschluss Rastnasen zur Verrastung mit der Verstrebung der inneren Belüftungsöffnung aufweist. Auf diese Weise wird der Drehverschluss mit der Gehäusewandung beziehungsweise mit dem auf die Gehäusewandung aufgesteckten Aufsteckteil drehbar verbunden. Hierzu hinterrasten die Rastnasen des Drehverschlusses mit dem Ring der Verstrebung. Die Rastnasen des Drehverschlusses und die Streben der Verstrebung sind dabei derart aufeinander abgestimmt, dass der Drehverschluss eine Öffnungsposition und eine Schließposition einnehmen kann.

Alternativ sieht eine bevorzugte Weiterbildung der Erfindung vor, dass der Drehverschluss über eine Achse mit dem Gehäuse verstellbar verbunden ist. Hierzu wird die Achse durch den Ring der Verstrebung innerhalb der inneren Belüftungsöffnung geführt und mit dem Drehverschluss verrastet. Auf diese Weise kann durch eine Drehbewegung des Drehverschlusses die Belüftung des Gehäuses geöffnet, geschlossen oder auch nur teilweise geöffnet werden.

In diesem Zusammenhang sieht eine bevorzugte Weiterbildung der Erfindung vor, dass die Achse auf der Kopfseite einen Schlitz aufweist. Auf diese Weise kann der Drehverschluss von der Gehäuseinnenseite aus verstellt und die Belüftung des Gehäuses entweder geöffnet oder geschlossen werden.

Weiterhin sieht eine bevorzugte Weiterbildung der Erfindung vor, dass in der Umrandung eine Mehrzahl von äußeren Belüftungsöffnungen vorgesehen ist und in der Öffnungsposition die Lage der radial umlaufenden äußeren Belüftungsöffnungen des Drehverschlusses der Lage der umlaufenden äußeren Belüftungsöffnungen in der unterbrochenen Aufkantung entlang der zweiten labyrinthartigen Kontur der Gehäusewandung entspricht. Dabei ist in Schließposition die Lage der radial umlaufenden äußeren Belüftungsöffnungen des Drehverschlusses zu der Lage der umlaufenden äußeren Belüftungsöffnungen in der Aufkantung entlang der zweiten labyrinthartigen Kontur der Gehäusewandung versetzt.

In Öffnungsposition hat das Gehäuse mit dem Belüftungselement gemäß einer bevorzugten Ausgestaltung der Erfindung eine Schutzklasse von IP 45 und in Schließposition von IP 55. Dabei sieht eine bevorzugte Weiterbildung der Erfindung vor, dass die Innenseite der Gehäusewandung oder die Innenseite des Aufsteckteils im Bereich der inneren Belüftungsöffnung eine Aufnahme für einen Filter, vorzugsweise einen Staubschutzfilter, aufweist und der Staubschutzfilter mit einem Haltering in der Aufnahme auf der Innenseite der Gehäusewandung oder der Innenseite der Aufsteckteils fixierbar ist. Auf diese Weise wird die innere Belüftungsöffnung staubdicht verschlossen, so dass das Gehäuse mit dem Belüftungselement gemäß einer bevorzugten Ausgestaltung in Öffnungsposition eine Schutzklasse von IP 65 oder IP 66 erreichen kann. Unter Verwendung eines Silikonfilters kann das Gehäuse in einer bevorzugten Ausgestaltung mit dem Belüftungselement eine Schutzklasse von IP 67 erzielen.

In diesem Zusammenhang sieht eine bevorzugte Weiterbildung der Erfindung vor, dass die Filterfläche ein Verhältnis zur Fläche der zweiten labyrinthartigen Kontur von wenigstens 1:3 aufweist und/oder die Summe der Durchmesser der äußeren Belüftungsöffnungen dem Weg zwischen einer äußeren Belüftungsöffnung und der inneren Belüftungsöffnung entspricht. Auf diese Weise wird ein Verhältnis geschaffen, das einen schnellen Ausgleich von Temperatur- und Druckänderungen zwischen dem geschlossenen Gehäuse und der Gehäuseumgebung auch bei einem sehr dichten Staubschutzfilter ermöglicht.

Eine bevorzugte Weiterbildung der Erfindung sieht vor, dass das Gehäuse ein erstes Belüftungselement im unteren Drittel der Gehäusewandung und ein zweites Belüftungselement im oberen Drittel der Gehäusewandung aufweist und das erste Belüftungselement diagonal zum zweiten Belüftungselement angeordnet ist. Auf diese Weise wird im Gehäuse ein Art Kaminwirkung erzeugt, was einen schnellen Ausgleich von Temperaturänderungen und Druckschwankungen zwischen dem Gehäuseinneren und der Gehäuseumgebung ermöglicht.

Eine weitere bevorzugte Weiterbildung der Erfindung sieht vor, dass in Öffnungsposition die zweite labyrinthartige Kontur und die äußeren Belüftungsöffnungen in der unterbrochenen Aufkantung und die erste labyrinthartige Kontur und die äußeren Belüftungsöffnungen des Drehverschlusses eine derartige Anordnung aufweisen, dass zutretendes Strahlwasser abgelenkt wird und nicht zu den inneren Belüftungsöffnungen gelangt.

In diesem Zusammenhang sieht eine weitere bevorzugte Weiterbildung der Erfindung vor, dass die zweite labyrinthartige Kontur der Gehäusewandung und die erste labyrinthartige Kontur des Drehverschlusses jeweils kleine ununterbrochene Rippen aufweisen. Auf diese Weise wird zuströmendes Wasser abgebremst.

Die Erfindung umfasst zudem ein Set mit einem Gehäuse, insbesondere ein Elektroinstallationsgehäuse, und einem Belüftungselement, wobei das Gehäuse mindestens eine Gehäusewandung aufweist und das Belüftungselement in die Gehäusewandung integrierbar ist, wobei das Belüftungselement eine gehäuseseitige zweite labyrinthartige Kontur und einen auf die zweite labyrinthartige Kontur aufsteckbaren Drehverschluss mit einer ersten labyrinthartigen Kontur umfasst, wobei die erste labyrinthartige Kontur des Drehverschlusses in die zweite gehäuseseitige labyrinthartige Kontur eingreift, dadurch gekennzeichnet, dass die Gehäusewandung eine Ausbrechmembran aufweist, wobei durch Ausbrechen der Ausbrechmembran aus der Gehäusewandung eine innere Belüftungsöffnung herstellbar ist und das Belüftungselement in die innere Belüftungsöffnung integrierbar ist.

Es ist somit ein wesentlicher Punkt der Erfindung ein universell einsetzbares Elektroinstallationsgehäuse anzugeben, in welches bei Bedarf mit geringem Aufwand eine innere Belüftungsöffnung in die Gehäusewandung, durch das Ausbrechen der Ausbrechmembran, herstellbar ist. Die Prägung der Ausbrechmembran in der Gehäusewandung hat zudem den Vorteil, dass die Lage und Größe der Belüftungsöffnung vorgegeben ist und nicht jedes Mal neu ermittelt werden muss. Somit können Elektroinstallationsgehäuse, die eine derartige Ausbrechmembran in der Gehäusewandung aufweisen, mit geringem Aufwand mit einem Belüftungselement nachgerüstet werden.

Die Ausgestaltungsmerkmale, für das erfindungsgemäße Gehäuse sind auch auf das Set mit dem Gehäuse und dem Belüftungselement anwendbar.

Nachfolgend wird die Erfindung anhand bevorzugter Ausführungsbeispiele unter Bezugnahme auf die Zeichnung näher erläutert. In der Zeichnung zeigen:
- Fig. 1a: eine Seitenansicht eines Belüftungselements gemäß einem ersten bevorzugten Ausführungsbeispiel der Erfindung,
- Fig. 1b: einen Schnitt durch das Belüftungselement gemäß dem ersten bevorzugten Ausführungsbeispiel der Erfindung,
- Fig. 2: eine isometrische Darstellung einer zweiten labyrinthartigen Kontur des Belüftungselementes gemäß dem ersten bevorzugten Ausführungsbeispiel der Erfindung,
- Fig. 3: eine isometrische Darstellung eines Drehverschlusses mit einer ersten labyrinthartigen Kontur gemäß dem ersten bevorzugten Ausführungsbeispiel der Erfindung,
- Fig. 4: eine isometrische Darstellung eines Halterings zur Befestigung eines Staubschutzfilters gemäß dem ersten bevorzugten Ausführungsbeispiel der Erfindung,
- Fig. 5: eine 3D-Ansicht eines Belüftungselements gemäß einem zweiten bevorzugten Ausführungsbeispiel der Erfindung,
- Fig. 6: eine Aufsicht auf die zweite Seite der Gehäusewandung gemäß dem zweiten bevorzugten Ausführungsbeispiel der Erfindung,
- Fig. 7: eine 3D-Ansicht eines Aufsteckteils gemäß dem bevorzugten Ausführungsbeispiel der Erfindung und
- Fig. 8: eine 3D-Ansicht eines Belüftungselements gemäß einem dritten bevorzugten Ausführungsbeispiel der Erfindung.

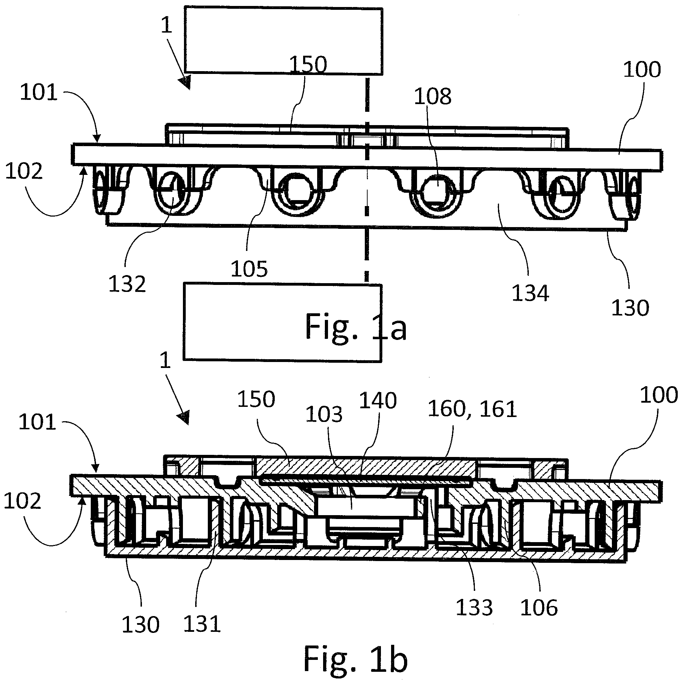

Aus den Figuren 1a und 1b ist ein Ausschnitt aus einem Elektroinstallationsgehäuse mit einem Belüftungselement 1 ersichtlich. Die Gehäusewandung 100 des Elektroinstallationsgehäuses weist eine innere Belüftungsöffnung 103 mit einer Verstrebung 160, umfassend einen Ring 161 und Streben 162, auf. Um die innere Belüftungsöffnung 103 ist auf der Außenseite 102 der Gehäusewandung 100 eine zweite labyrinthartige Kontur 106 und eine unterbrochene Aufkantung 105 mit äußeren Belüftungsöffnungen 108 angeordnet. Ein Drehverschluss 130 mit einer ersten labyrinthartigen Kontur 131 und äußeren Belüftungsöffnungen 132 in seiner Umrandung 134 greift in die zweite labyrinthartige Kontur 106 der Gehäusewandung 100 ein. Weiterhin weist der Drehverschluss 130 Rastnasen 133 auf, die mit dem Ring 161 der Verstrebung 160 der inneren Belüftungsöffnung 103 verrasten. Der Drehverschluss 130 ist auf diese Weise drehbar mit der Gehäusewandung 100 verbunden, wobei die Rastnasen 133 des Drehverschlusses 130 und die Verstrebung 160 der inneren Belüftungsöffnung 133 derart aufeinander abgestimmt sind, dass der Drehverschluss 130 eine Öffnungsposition und eine Schließposition einnehmen kann.

Auf der Innenseite 101 der Gehäusewandung 100 überdeckt ein Staubschutzfilter 140 die innere Belüftungsöffnung 103. Dabei liegt der Staubschutzfilter 140 unter anderem auch an der Verstrebung 160 der inneren Belüftungsöffnung 103 an. Mit einem Haltering 150 wird der Staubschutzfilter 140 in der Lage fixiert. Auf diese Weise wird die innere Belüftungsöffnungen 103 staubdicht abgedichtet.

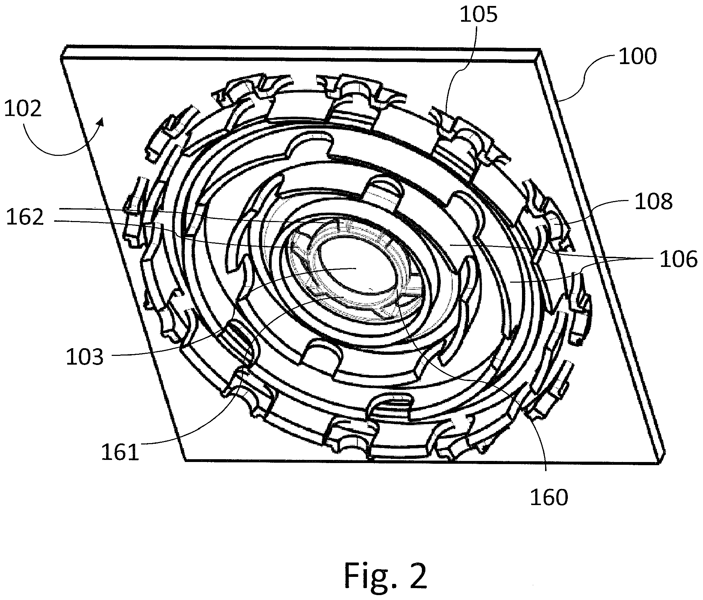

In Figur 2 ist die Außenseite 102 der Gehäusewandung 100 mit der zweiten labyrinthartigen Kontur 106 gezeigt. Die zweite labyrinthartige Kontur 106 ist mit der unterbrochenen Aufkantung 105 umrandet, wobei die unterbrochene Aufkantung 105 äußere Belüftungsöffnungen 108 aufweist. Die Gehäusewandung 100 weist in der Mitte der zweiten labyrinthartigen Kontur 106 die innere Belüftungsöffnung 103 mit der Verstrebung 160 auf, wobei die Verstrebung 160 einen Ring 161 umfasst, der durch mehrere Streben 162 mittig in der inneren Belüftungsöffnung 103 fixiert ist. Ausgehend von der Innenseite 101 des Gehäuses findet über die innere Belüftungsöffnung 103, die zweite labyrinthartige Kontur 106 und die äußeren Belüftungsöffnungen 108 ein Luftaustausch mit der Umgebung statt.

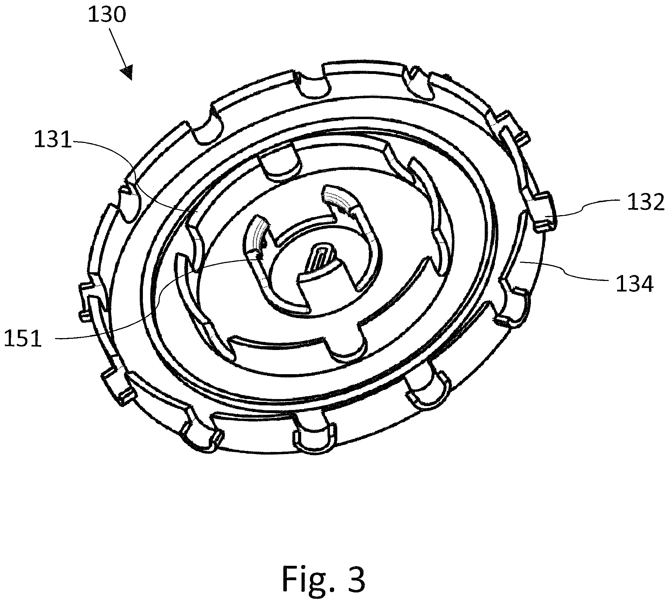

In Figur 3 ist der Drehverschluss 130 mit der ersten labyrinthartigen Kontur 131 gezeigt. Die Umrandung 134 des Drehverschlusses 130 weist radial umlaufende äußere Belüftungsöffnungen 132 auf. Der Drehverschluss 130 weist in der Mitte Rastnasen 151 zur Verrastung mit der in Fig. 2 gezeigten Verstrebung 160 der inneren Belüftungsöffnung 103 auf. Auf diese Weise ist der Drehverschluss 130 drehbar mit der Gehäusewandung 100 verbindbar. Über den Drehverschluss 130 kann die Belüftung des Elektroinstallationsgehäuses reguliert werden. In Öffnungsposition entspricht die Lage der äußeren Belüftungsöffnungen 132 des Drehverschlusses 130 der Lage der äußeren Belüftungsöffnungen 108 der Gehäusewandung 100. Auf diese Weise kann ein Luftaustausch zwischen dem Gehäuseinneren über die inneren Belüftungsöffnungen 103, der ersten labyrinthartigen Kontur 106, der zweiten labyrinthartigen Kontur 131 und den äußeren Belüftungsöffnungen 108, 132 mit der Umgebung erfolgen. In Schließposition ist die Lage der äußeren Belüftungsöffnungen 132 des Drehverschlusses 130 mit den äußeren Belüftungsöffnungen 108 der Gehäusewandung 100 versetzt, so dass nur ein geringer oder gar kein Luftaustausch zwischen dem Gehäuseinneren und der Umgebung stattfindet.

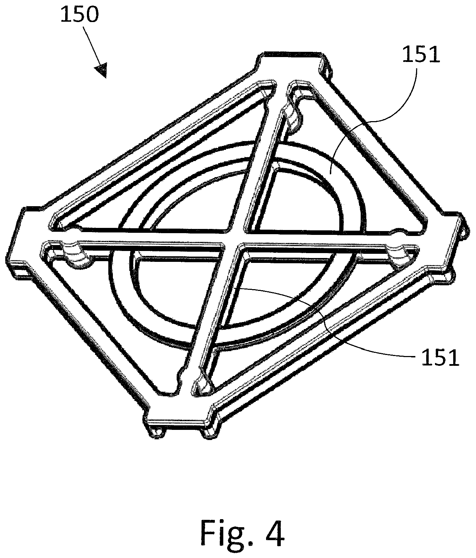

In Figur 4 ist der Haltering 150 zur Fixierung des Staubschutzfilters 140 auf der inneren Belüftungsöffnungen 103 gezeigt. Der Haltering 150 weist eine Verstrebung 151 auf über welche der Staubschutzfilter 140 an die Verstrebung 160 und die Umrandung der inneren Belüftungsöffnung 103 der Gehäusewandung 100 gepresst wird. Auf diese Weise wird die innere Belüftungsöffnung 103 staubdicht abgedichtet.

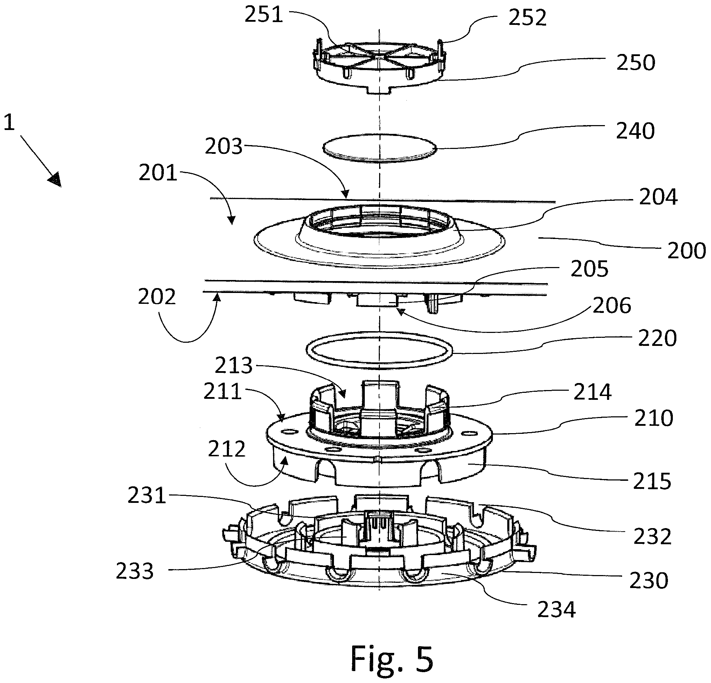

Die Figur 5 zeigt ein Elektroinstallationsgehäuse mit einem alternativen Aufbau eines Belüftungselements 1. Die Gehäusewandung 200 mit der Innenseite 201 und der Außenseite 202 weist eine innere Belüftungsöffnung 203 auf. Die innere Belüftungsöffnung 203 ist auf der Innenseite 201 mit einer Aufkantung 204 umrandet. Auf diese Weise wird die Steifigkeit dünnwandiger Gehäusewandungen 200 im Bereich der inneren Belüftungsöffnung 203 erhöht. Die Außenseite 202 der Gehäusewandung 200 weist zwei im Abstand zur inneren Belüftungsöffnung 203 umlaufende, unterbrochene Aufkantungen 205 mit äußeren Belüftungsöffnungen 208 auf, welche einen ersten Teil der zweiten labyrinthartigen Kontur 206 bilden.

Ein Aufsteckteil 210, umfassend eine erste Seite 211, eine zweiten Seite 212 und eine innere Belüftungsöffnung 213, ist mit seiner ersten Seite 211 auf die Außenseite 202 der Gehäusewandung 200 aufsteckbar. Hierzu greifen die um die innere Belüftungsöffnung 213 angeordneten Rastnasen 214 in die innere Belüftungsöffnung 203 der Gehäusewandung 200 ein und hinterrasten mit der um die innere Belüftungsöffnung 203 umlaufende Aufkantung 204. Die zweite Seite 212 des Aufsteckteils 210 weist im Abstand um die innere Belüftungsöffnung 213 zwei unterbrochene Aufkantungen 215 auf, welche einen zweiten Teil der zweiten labyrinthartigen Kontur 206 bilden. Die zweite labyrinthartige Kontur 206 wird demnach durch den ersten Teil auf der Außenseite 202 der Gehäusewandung 200 und durch den zweiten Teil auf der zweiten Seite 212 des Aufsteckteils 210 gebildet.

Zur Abdichtung des umlaufenden Spaltes zwischen der inneren Belüftungsöffnung 203 der Gehäusewandung 200 und den in die innere Belüftungsöffnung 203 eingreifenden Rastnasen 214 des Aufsteckteils 210 ist ein Dichtring 220 zwischen dem Aufsteckteil 210 und der Gehäusewandung 200 vorgesehen. Auf diese Weise ist der umlaufende Spalt staubdicht und wasserdicht abdichtbar.

Auf die zweite Seite 212 des Aufsteckteils 210 ist ein Drehverschluss 230, umfassend eine erste labyrinthartige Kontur 231 mit äußeren Belüftungsöffnungen 232, aufsteckbar. Hierzu greifen die Rastnasen 233 des Drehverschlusses 230 in eine Verstrebung 218 der inneren Belüftungsöffnung 213 des Aufsteckteils 210 ein. Die Rastnasen 233 des Drehverschlusses 230 und die Verstrebung 218 der inneren Belüftungsöffnung 213 sind dabei derart aufeinander abgestimmt, dass durch eine Verdrehung des Drehverschlusses 230 gegenüber dem Aufsteckteil 210 die äußeren Belüftungsöffnungen 208, 232 sowohl eine Schließposition als auch eine Öffnungsposition einnehmen können.

Die Staubdichtigkeit und Wasserdichtigkeit des Belüftungselements 1 wird durch einen Staubschutzfilter 240 erhöht. Der Staubschutzfilter 240 ist ausgehend von der Innenseite 201 der Gehäusewandung 200 durch die innere Belüftungsöffnung 203 auf die Verstrebung 218 der inneren Belüftungsöffnungen 213 des aufgesteckten Aufsteckteils 210 auflegbar und mit einem Halterring 250 fixierbar. Hierzu greift der Haltering 250 zwischen die Rastnasen 214 des Aufsteckteils 210 ein. Am Haltering 250 sind Rastnasen 252 vorgesehen, die in entsprechende Laschen mit Rastöffnungen 216 des Aufsteckteils 210 verrasten. Der Haltering 250 weist zudem eine Verstrebung 251 auf, so dass der Staubschutzfilter 240 an die Verstrebung 218 der inneren Belüftungsöffnung 213 anpressbar ist. Auf diese Weise wird der Staubschutzfilter 240 lagesicher fixiert und die Dichtigkeit des Belüftungselements erhöht.

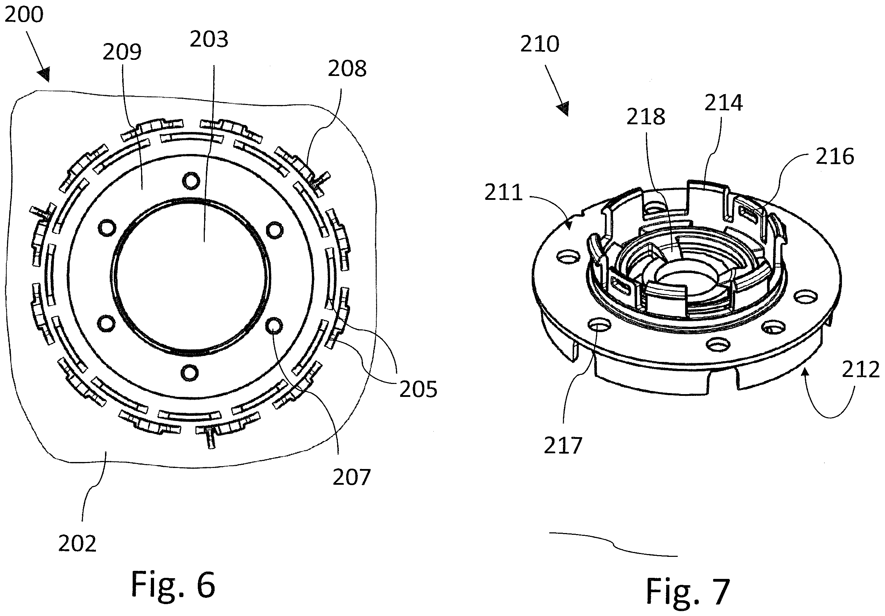

Die Figur 6 zeigt die Außenseite 202 der Gehäusewandung 200 mit der inneren Belüftungsöffnung 203 und der im Abstand zur inneren Belüftungsöffnung 203 unterbrochenen Aufkantungen 205 mit äußeren Belüftungsöffnungen 208. Zwischen der inneren Belüftungsöffnung 203 und der im Abstand zur inneren Belüftungsöffnung 203 angeordneten unterbrochenen Aufkantungen 205 ist ein flächiger Bereich 209 angeordnet, welcher zur Auflage der ersten Seite 211 des auf die Außenseite 201 der Gehäusewandung 200 aufgesteckten Aufsteckteils 210 dient. Zapfen 207 im flächigen Bereich 209 greifen in Materialausnehmungen 217 auf der ersten Seite 211 des Aufsteckteils 210 ein, so dass das auf die Gehäusewandung aufsteckbare Aufsteckteil lagesicher mit der Gehäusewandung verbindbar ist. Dies ist insofern wichtig, damit sich der zweite Teil der zweiten labyrinthartige Kontur 206 nicht verdreht, da ansonsten die Funktionalität des Belüftungselements eingeschränkt sein kann.

In Figur 7 ist das auf die Außenseite 202 der Gehäusewandung 200 aufsteckbare Aufsteckteil 210 gezeigt. Die erste Seite 211 weist Materialausnehmungen 217 auf, welche beim Aufstecken des Aufsteckteils auf die Gehäusewandung in Zapfen 207 eingreifen, wodurch das Aufsteckteil 210 lagesicher mit der Gehäusewandung 200 verbunden wird. Im Bereich der inneren Belüftungsöffnung 213 ist eine Verstrebung 218 welche als Auflager für den in Figur 5 dargestellten Staubschutzfilter 240 dient. Der Staubschutzfilter 240 wird über den Haltering 250 fixiert, wobei der Halterring 250 hierzu mit seinen Rastnasen 252 in die Laschen mit den Rastöffnungen 216 eingreift.

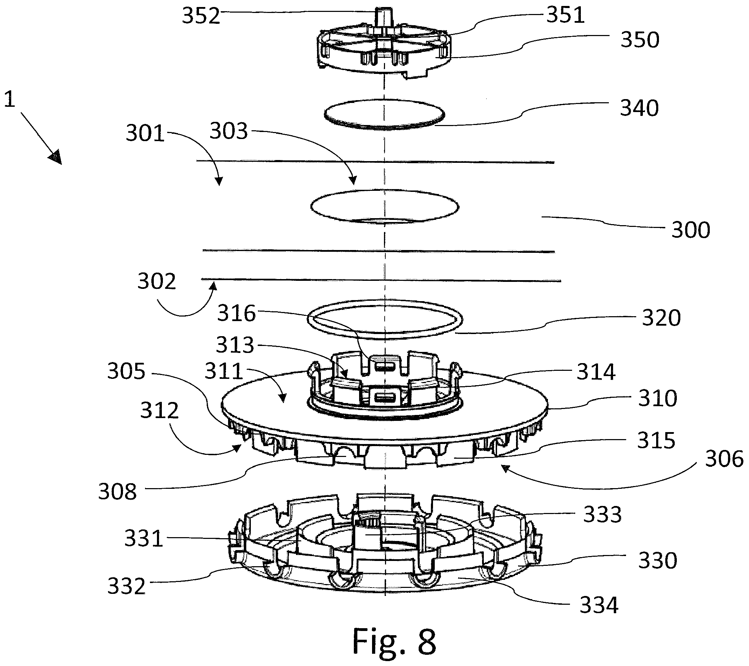

Die Figur 8 zeigt ein Elektroinstallationsgehäuse mit einem weiteren alternativen Aufbau eines Belüftungselements 1, welches insbesondere zum Nachrüsten bereits bestehender Elektroinstallationsgehäuse geeignet ist. Im Vergleich zu dem in Figur 5 gezeigten Aufbau des Belüftungselements unterscheidet sich der Aufbau des in Figur 8 gezeigten Belüftungselementes in der Ausgestaltung der Gehäusewandung 300 und im Aufsteckteil 310.

Die Gehäusewandung 300 weist eine Innenseite 301, eine Außenseite 302 und eine innere Belüftungsöffnung 303 auf. Die innere Belüftungsöffnung 303 kann beispielsweise durch eine Ausbrechmembran, also durch das Ausbrechen der vorgeprägten Membran aus der Gehäusewandung, herstellbar sein. Ein derartiges Vorprägen einer Ausbrechmembran in der Gehäusewandung bietet sich insbesondere für universell einsetzbare Elektroinstallationsgehäuse an. Bei Bedarf kann somit mit geringem Aufwand ein Belüftungselement nachträglich installiert werden, wobei sich das Vorprägen einer Ausbrechmembran in der Gehäusewandung nicht nur auf dieses Beispiel beschränkt, sondern auf alle in dieser Patentschrift genannten Beispiele anwendbar ist.

Ein Aufsteckteil 310, umfassend eine erste Seite 311, eine zweiten Seite 312 und eine innere Belüftungsöffnung 313, ist mit seiner ersten Seite 311 auf die Außenseite 302 der Gehäusewandung 300 aufsteckbar. Hierzu greifen die um die innere Belüftungsöffnungen 313 angeordneten Rastnasen 314 in die innere Belüftungsöffnung 303 der Gehäusewandung 300 ein und hinterrasten mit der Innenseite 301 der Gehäusewandung 300. Die zweite Seite 312 des Aufsteckteils 310 weist eine zweite labyrinthartige Kontur 306 mit äußeren Belüftungsöffnungen 308 auf.

Zur Abdichtung des umlaufenden Spaltes zwischen der inneren Belüftungsöffnung 303 der Gehäusewandung 300 und den in die innere Belüftungsöffnung 303 eingreifenden Rastnasen 314 des Aufsteckteils 310 ist ein Dichtring 320 zwischen dem Aufsteckteil 310 und der Gehäusewandung 300 vorgesehen. Auf diese Weise ist der umlaufende Spalt staubdicht und wasserdicht abdichtbar.

Auf die zweite Seite 312 des Aufsteckteils 310 ist ein Drehverschluss 330, umfassend eine erste labyrinthartige Kontur 331 mit äußeren Belüftungsöffnungen 332 aufsteckbar. Hierzu greifen die Rastnasen 333 des Drehverschlusses 330 in eine Verstrebung 318 der inneren Belüftungsöffnung 313 des Aufsteckteils 310 ein. Die Rastnasen 333 des Drehverschlusses 330 und die Verstrebung der inneren Belüftungsöffnung 313 sind dabei derart aufeinander abgestimmt, dass durch eine Verdrehung des Drehverschlusses 330 gegenüber dem Aufsteckteil 310 die äußeren Belüftungsöffnungen 332 sowohl eine Schließposition als auch eine Öffnungsposition einnehmen können.

Die Staubdichtigkeit und Wasserdichtigkeit des Belüftungselements wird durch einen Staubschutzfilter 340 erhöht. Der Staubschutzfilter 340 ist ausgehend von der Innenseite 301 der Gehäusewandung 300 durch die innere Belüftungsöffnung 303 auf die Verstrebung der inneren Belüftungsöffnung 313 des aufgesteckten Aufsteckteils 310 auflegbar und mit einem Halterring 350 fixierbar. Hierzu greift der Haltering 350 zwischen die Rastnasen 314 des Aufsteckteils 310 ein und verrastet. Der Haltering 350 weist zudem eine Verstrebung 351 auf, so dass der Staubschutzfilter 340 an die Verstrebung 318 der inneren Belüftungsöffnung 313 angepresst wird. Auf diese Weise wird der Staubschutzfilter 340 lagesicher fixiert und die Dichtigkeit des Belüftungselements erhöht.
- 1: Belüftungselement
- 100, 200, 300: Gehäusewandung
- 101, 201, 301: Innenseite
- 102, 202, 302: Außenseite
- 103, 203, 303: innere Belüftungsöffnung
- 105, 205, 305: unterbrochene Aufkantung
- 106, 206, 306: zweite labyrinthartige Kontur
- 108, 208, 308: äußere Belüftungsöffnungen
- 130, 230, 330: Drehverschluss
- 131, 231, 331: erste labyrinthartige Kontur
- 132, 232, 332: äußere Belüftungsöffnung
- 133, 233, 333: Rastnasen
- 134, 234, 334: Umrandung
- 140, 240, 340: Staubschutzfilter
- 150, 250, 350: Haltering
- 151, 251, 351: Verstrebung
- 160: Verstrebung
- 161: Ring
- 162: Streben
- 204: Aufkantung
- 207: Zapfen
- 209: flächiger Bereich
- 210, 310: Aufsteckteil
- 211, 311: erste Seite
- 212, 312: zweite Seite
- 213, 313: innere Belüftungsöffnung
- 214, 314: Rastnasen
- 215, 315: unterbrochene Aufkantung
- 216, 316: Lasche mit Rastöffnung
- 217: Materialausnehmung
- 218, 318: Verstrebung
- 220, 320: Dichtring
- 252, 352: Rastnasen

## Patentansprüche

1. Gehäuse, insbesondere Elektroinstallationsgehäuse,
mit einer eine innere Belüftungsöffnung (103, 203, 303) aufweisenden Gehäusewandung (100, 200, 300) und einem in der Gehäusewandung (100, 200, 300) vorgesehenen Belüftungselement (1), wobei
das Belüftungselement (1) als Drehverschluss (130, 230, 330) zum Öffnen bzw. Schließen der inneren Belüftungsöffnung (103, 203, 303) ausgestaltet ist und der Drehverschluss (130, 230, 330) auf seiner der Gehäusewandung (100, 200, 300) zugewandten Seite eine erste labyrinthartige Kontur (131, 231, 331) aufweist,
die Gehäusewandung (100, 200, 300) auf ihrer Außenseite (102, 202, 302) eine die innere Belüftungsöffnung (103, 203, 303) umgebende zweite labyrinthartige Kontur (106, 206, 306) aufweist, und
die erste labyrinthartige Kontur (131, 231, 331) des Drehverschlusses (130, 230, 330) in die zweite labyrinthartige Kontur (106, 206, 306) der Gehäusewandung (100, 200, 300) eingreift, **dadurch gekennzeichnet,**
**dass** die zweite labyrinthartige Kontur (106, 206, 306) der Gehäusewandung (100, 200, 300) durch eine unterbrochene Aufkantung (105, 205, 305) umrandet ist und die unterbrochene Aufkantung (105, 205, 305) wenigstens eine äußere Belüftungsöffnung (108, 208, 308) aufweist.

2. Gehäuse nach Anspruch 1, **dadurch gekennzeichnet, dass** die zweite labyrinthartige Kontur (106) auf der Außenseite (101) einstückig mit der Gehäusewandung (100) ausgestaltet ist.

3. Gehäuse nach Anspruch 1, **dadurch gekennzeichnet, dass** die zweite labyrinthartige Kontur (306) über ein Aufsteckteil (310) auf die Außenseite (302) der Gehäusewandung (300) aufgesteckt ist.

4. Gehäuse nach Anspruch 1, **dadurch gekennzeichnet, dass** ein erster Teil der zweiten labyrinthartigen Kontur (206) einstückig mit der Außenseite (202) der Gehäusewandung (200) ausgestaltet ist und ein zweiter Teil der zweiten labyrinthartigen Kontur (206) über ein Aufsteckteil (210) auf die Außenseite (202) der Gehäusewandung (200) aufgesteckt ist.

5. Gehäuse nach einem der Ansprüche 1 bis 4, **dadurch gekennzeichnet, dass** der Drehverschluss (130, 230, 330) in seiner Umrandung (134, 234, 334) wenigstens eine äußere Belüftungsöffnung (132, 232, 332) aufweist.

6. Gehäuse nach einem der Ansprüche 1 bis 5, **dadurch gekennzeichnet, dass** die innere Belüftungsöffnung der Gehäusewandung (103) oder die innere Belüftungsöffnung des Aufsteckteils (213, 313) eine Verstrebung (160, 218, 318) aufweist.

7. Gehäuse nach einem der Ansprüche 1 bis 6, **dadurch gekennzeichnet, dass** der Drehverschluss (130, 230, 330) Rastnasen (133, 233, 333) zur Verrastung mit der Verstrebung (160, 218, 318) der inneren Belüftungsöffnung (103, 213, 313) aufweist.

8. Gehäuse nach einem der Ansprüche 1 bis 7, **dadurch gekennzeichnet, dass** in der Umrandung (134, 234, 334) eine Mehrzahl von äußeren Belüftungsöffnungen (132, 232, 332) vorgesehen ist und in der Öffnungsposition die Lage der radial umlaufenden äußeren Belüftungsöffnungen (132, 232, 332) des Drehverschlusses (6) der Lage der umlaufenden äußeren Belüftungsöffnungen (108, 208, 308) in der unterbrochenen Aufkantung (105, 205, 305) entlang der zweiten labyrinthartigen Kontur (106, 206, 306) entspricht.

9. Set mit einem Gehäuse, insbesondere ein Elektroinstallationsgehäuse, und einem Belüftungselement, wobei das Gehäuse mindestens eine Gehäusewandung (100, 200, 300) aufweist und das Belüftungselement (1) in die Gehäusewandung (100, 200, 300) integrierbar ist, wobei das Belüftungselement (1) eine gehäuseseitige zweite labyrinthartige Kontur (106, 206, 306) und einen auf die zweite labyrinthartige Kontur (106, 206, 306) aufsteckbaren Drehverschluss (130, 230, 330) mit einer ersten labyrinthartigen Kontur (131, 231, 331) umfasst, wobei
die erste labyrinthartige Kontur (131, 231, 331) des Drehverschlusses (130, 230, 330) in die gehäuseseitige zweite labyrinthartige Kontur (106, 206, 306) eingreift, **dadurch gekennzeichnet,**
**dass** die Gehäusewandung (100, 200, 300) eine Ausbrechmembran aufweist, wobei
durch Ausbrechen der Ausbrechmembran aus der Gehäusewandung eine innere Belüftungsöffnung (103, 203, 303) herstellbar ist und das Belüftungselement (1) in die innere Belüftungsöffnung (103, 203, 303) integrierbar ist.

## Claims

1. A housing, in particular an electrical installation housing,
having a housing wall (100, 200, 300), which has an inner ventilation opening (103, 203, 303), and having a ventilation element (1), which is provided in the housing wall (100, 200, 300), wherein
the ventilation element (1) is designed as a twist-off cap (130, 230, 330) for opening and closing the inner ventilation opening (103, 203, 303), and the twist-off cap (130, 230, 330) has a first labyrinth-like contour (131, 231, 331) on its side facing the housing wall (100, 200, 300),
the housing wall (100, 200, 300), on its outer side (102, 202, 302), has a second labyrinth-like contour (106, 206, 306) surrounding the inner ventilation opening (103, 203, 303), and
the first labyrinth contour (131, 231, 331) of the twist-off cap (130, 230, 330) engages in the second labyrinth-like contour (106, 206, 306) of the housing wall (100, 200, 300), **characterised in that**
the second labyrinth-like contour (106, 206, 306) of the housing wall (100, 200, 300) is edged by an interrupted upright wall (105, 205, 305), and the interrupted upright wall (105, 205, 305) has at least one outer ventilation opening (108, 208, 308).

2. The housing according to claim 1, **characterised in that** the second labyrinth-like contour (106), on the outer side (101), is formed integrally with the housing wall (100).

3. The housing according to claim 1, **characterised in that** the second labyrinth-like contour (306) is plugged onto the outer side (302) of the housing wall (300) by means of a plug-on part (310).

4. The housing according to claim 1, **characterised in that** a first part of the second labyrinth-like contour (206) is formed integrally with the outer side (202) of the housing wall (200) and a second part of the second labyrinth-like contour (206) is plugged onto the outer side (202) of the housing wall (200) by means of a plug-on part (210).

5. The housing according to any one of claims 1 to 4, **characterised in that** the twist-off cap (130, 230, 330) has at least one outer ventilation opening (132, 232, 332) in its edging (134, 234, 334).

6. The housing according to any one of claims 1 to 5, **characterised in that** the inner ventilation opening of the housing wall (103) or the inner ventilation opening of the plug-on part (213, 313) has a bracing (160, 218, 318) .

7. The housing according to any one of claims 1 to 6, **characterised in that** the twist-off cap (130, 230, 330) has catch lugs (133, 233, 333) for latching with the bracing (160, 218, 318) of the inner ventilation opening (103, 213, 212).

8. The housing according to any one of claims 1 to 7, **characterised in that** a plurality of outer ventilation openings (132, 232, 332) are provided in the edging (134, 234, 334), and in the opening position the position of the radially peripheral outer ventilation openings (132, 232, 332) of the twist-off cap (6) corresponds to the position of the peripheral outer ventilation openings (108, 208, 308) in the interrupted upright wall (105, 205, 305) along the second labyrinth-like contour (106, 206, 306).

9. A set with a housing, in particular an electrical installation housing, and a ventilation element, wherein the housing has at least one housing wall (100, 200, 300) and the ventilation element (1) can be integrated in the housing wall (100, 200, 300), wherein the ventilation element (1) comprises a housing-side second labyrinth-like contour (106, 206, 306) and a twist-off cap (130, 230, 330) that can be plugged onto the second labyrinth-like contour (106, 206, 306) and that has a first labyrinth-like contour (131, 231, 331), wherein
the first labyrinth-like contour (131, 231, 331) of the twist-off cap (130, 230, 330) engages in the housing-side second labyrinth-like contour (106, 206, 306), **characterised in that**
the housing wall (100, 200, 300) has a breakaway membrane, wherein
by breaking away the breakaway membrane from the housing wall, an inner ventilation opening (103, 203, 303) can be produced and the ventilation element (1) can be integrated in the inner ventilation opening (103, 203, 303).

## Revendications

1. Boîtier, notamment, boîtier d'installation électrique,
pourvu d'une paroi de boîtier (100, 200, 300) présentant un orifice de ventilation intérieur (103, 203, 303) et d'un élément de ventilation (1) prévu dans la paroi de boîtier (100, 200, 300), où
l'élément de ventilation (1) est conçu sous la forme d'une fermeture rotative (130, 230, 330) destinée à l'ouverture, respectivement, à la fermeture de l'orifice de ventilation intérieur (103, 203, 303) et la fermeture rotative (130, 230, 330) présente un premier contour (131, 231, 331) en forme de labyrinthe sur son côté orienté vers la paroi de boîtier (100, 200, 300),
la paroi de boîtier (100, 200, 300) présente sur son côté extérieur (102, 202, 302), un deuxième contour (106, 206, 306) en forme de labyrinthe entourant l'orifice de ventilation intérieur (103, 203, 303), et
le premier contour (131, 231, 331) en forme de labyrinthe de la fermeture rotative (130, 230, 330) se met en prise à l'intérieur du deuxième contour (106, 206, 306) en forme de labyrinthe de la paroi de boîtier (100, 200, 300), **caractérisé en ce**
**que** le deuxième contour (106,206, 306) en forme de labyrinthe de la paroi de boîtier (100, 200, 300) est entouré par un rebord (105, 205, 305) interrompue et le rebord (105, 205, 305) interrompu présente au moins un orifice de ventilation extérieur (108, 208, 308).

2. Boîtier selon la revendication 1, **caractérisé en ce que** le deuxième contour (106) en forme de labyrinthe est conçu d'un seul tenant avec la paroi de boîtier (100) sur le côté extérieur (101).

3. Boîtier selon la revendication 1, **caractérisé en ce que** le deuxième contour (306) en forme de labyrinthe est conçu par le biais d'une pièce à rapporter sur le dessus (310) sur le côté extérieur (302) de la paroi de boîtier (300).

4. Boîtier selon la revendication 1, **caractérisé en ce qu'**une première partie du deuxième contour (206) en forme de labyrinthe est conçue d'un seul tenant avec le côté extérieur (202) de la paroi de boîtier (200) et une deuxième partie du deuxième contour (206) en forme de labyrinthe est rapportée sur le côté extérieur (202) de la paroi de boîtier (200) par le biais d'une pièce à rapporter sur le dessus (210).

5. Boîtier selon l'une des revendications 1 à 4, **caractérisé en ce que** la fermeture rotative (130, 230, 330) présente au moins un orifice de ventilation extérieur (132,232, 332) dans son rebord (134, 234, 334).

6. Boîtier selon l'une des revendications 1 à 5, **caractérisé en ce que** l'orifice de ventilation intérieur de la paroi de boîtier (103) ou l'orifice de ventilation intérieur de la pièce à rapporter sur le dessus (213, 313) présentent une contre-fiche (160, 218, 318).

7. Boîtier selon l'une des revendications 1 à 6, **caractérisé en ce que** la fermeture rotative (130, 230, 330) présente des moyens d'encliquetage (133, 233, 333) pour le verrouillage avec la contre-fiche (160, 218, 318) de l'orifice de ventilation intérieur (103, 213, 313).

8. Boîtier selon l'une des revendications 1 à 7, **caractérisé en ce qu'**un grand nombre d'orifices de ventilation extérieurs (132, 232, 332) est prévu dans le rebord (134, 234, 334), et, dans la position d'ouverture, la localisation des orifices de ventilation extérieurs (132,232, 332) de la fermeture rotative (6) périphériques dans le sens radial correspond à la localisation des orifices de ventilation extérieurs (108, 208, 308) périphériques dans le rebord (105, 205, 305) interrompu le long du deuxième contour (106, 206, 306) en forme de labyrinthe.

9. Ensemble pourvu d'un boîtier, notamment, d'un boîtier d'installation électrique, et d'un élément de ventilation, dans lequel le boîtier présente au moins une paroi de boîtier (100, 200, 300) et l'élément de ventilation (1) est intégrable dans la paroi de boîtier (100, 200, 300), où l'élément de ventilation (1) comprend un deuxième contour (106, 206,306) en forme de labyrinthe du côté du boîtier et une fermeture rotative (130, 203, 330) pouvant être rapportée sur le dessus du deuxième contour (106, 206, 306) en forme de labyrinthe avec un premier contour (131, 231, 331) en forme de labyrinthe, où
le premier contour (131, 231, 331) en forme de labyrinthe de la fermeture rotative (130, 230, 330) se met en prise dans le deuxième contour (106, 206, 306) en forme de labyrinthe, **caractérisé en ce**
**que** la paroi de boîtier (100, 200, 300) présente une membrane d'éclatement, où,
par l'éclatement de la membrane d'éclatement, un orifice de ventilation intérieur (103, 203, 303) peut être créé et l'élément de ventilation (1) peut être intégré dans l'orifice de ventilation intérieur (103, 203, 303).
